(19) Europäisches Patentamt
European Patent Office
Office européen des brevets

(11) **EP 4 422 364 A1**

(12) **EUROPEAN PATENT APPLICATION**
published in accordance with Art. 153(4) EPC

(43) Date of publication:
**28.08.2024 Bulletin 2024/35**

(21) Application number: **22883223.4**

(22) Date of filing: **01.09.2022**

(51) International Patent Classification (IPC):
*H05K 3/32* (2006.01)      *C08G 18/00* (2006.01)
*H01B 1/22* (2006.01)

(52) Cooperative Patent Classification (CPC):
**C08G 18/00; H01B 1/22; H05K 3/32**

(86) International application number:
**PCT/JP2022/032964**

(87) International publication number:
**WO 2023/067911 (27.04.2023 Gazette 2023/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.10.2021 JP 2021173049**

(71) Applicant: **Toyobo Co., Ltd.**
**Kita-ku**
**Osaka-shi, Osaka 530-0001 (JP)**

(72) Inventors:
• **TAKIMOTO, Naomi**
  **Otsu-shi, Shiga 520-0292 (JP)**
• **IRIE, Michihiko**
  **Otsu-shi, Shiga 520-0292 (JP)**
• **KONDO, Takashi**
  **Otsu-shi, Shiga 520-0292 (JP)**

(74) Representative: **Müller-Boré & Partner**
**Patentanwälte PartG mbB**
**Friedenheimer Brücke 21**
**80639 München (DE)**

(54) **ELECTROCONDUCTIVE CURED PRODUCT**

(57)    An object of the present invention is to provide a flexible cured product capable of preparing the cured product having excellent electroconductivity and adhesiveness at a lower temperature, and an electronic device thereof.

The present invention relates to an electroconductive cured product, wherein the electroconductive cured product comprises a resin having a urethane bond and electroconductive particles, the electroconductive cured product has storage modulus of 50 MPa to 1000 MPa at 25 °C, and the electroconductive cured product has specific resistivity of less than $2.0 \times 10^{-4}$ $\Omega \cdot$cm.

[FIG.1]

**Description**

TECHNICAL FIELD

The present invention relates to an electroconductive cured product having flexibility for adhering an electronic part and an electronic device thereof.

BACKGROUND ART

Flexible hybrid electronics (hereinafter, referred to as FHE) has been developed in association with expansion of uses of electronic devices. In the FHE, a semiconductor part such as a chip or a capacitor is mounted on a wire formed on a flexible base material. However, the semiconductor part is rigid and cannot be deformed, and thus a connection portion between the semiconductor part and the wire is required to be made of a flexible and low-elasticity electroconductive adhesive that can follow deformation of the base material so as to be able to maintain the connection of the part even at the time of the deformation.

As a base material of the FHE, a flexible base material such as polyethylene terephthalate (PET), polyethylene naphthalate (PEN), polypropylene (PP), and polyurethane (PU), which are inferior in heat resistance to a base material used for an existing electronic device, is used in some cases. Therefore, the electroconductive adhesive for joining the part is also required to achieve adhesion at a low temperature corresponding to the heat resistance of the base material.

In view of this requirement, Patent Literature 1 discloses a technology in which silver powder and/or silver coat metal powder is combined with a liquid epoxy resin and a liquid phenoxy resin, and a latent glutaric acid generating compound is added thereto in a given amount, for the purpose of providing an electroconductive adhesive that controls increase in the viscosity thereof at room temperature and that has excellent electrical conductivity and adhesion strength.

In addition, Patent Literature 2 discloses a technology of an electroconductive adhesive having favorable flexibility and high electrical conductivity in which silver particles are combined with a polyether polymer that has a hydrolyzable silyl group as a terminal group and that has a main chain having a repeating unit represented by the formula -$R^1$-O- (in the formula, $R^1$ is a hydrocarbon group having 1 to 10 carbon atoms).

Patent Literature 3 discloses a technology relating to an electroconductive composition having excellent tackiness before curing and having a small change in the resistance when being stretched after curing in which a polyol, a blocked isocyanate, and an electroconductive filler having an aspect ratio of 2 or higher are combined.

Patent Literature 4 discloses a technology of an electroconductive composition having improved electrical conductivity in which an electroconductive metal having a metal oxide and a lubricant present on a surface thereof and an isocyanate component are reacted with each other at the time of heating and curing, the metal oxide and the lubricant are at least partially eliminated from the surface of the electroconductive metal.

CITATION LIST

PATENT LITERATURE

[PTL 1] Japanese Patent No. 5200662
[PTL 2] Japanese Laid-Open Patent Publication No. 2018-48286
[PTL 3] Japanese Laid-Open Patent Publication No. 2020-150236
[PTL 4] Japanese Patent No. 4467439

SUMMARY OF THE INVENTION

PROBLEMS TO BE SOLVED BY THE INVENTION

As described above, a flexible electroconductive adhesive that can follow deformation of a base material has been currently required. However, although an electroconductive adhesive used for an ordinary electronic device such as the electroconductive adhesive in Patent Literature 1 has excellent adhesive force and electrical conductivity, the electroconductive adhesive has a problem of lacking flexibility. Meanwhile, the electroconductive adhesive disclosed in Patent Literature 2 has excellent flexibility and specific resistance, and there is a problem of requiring a high curing temperature. Furthermore, the electroconductive adhesives in which a blocked isocyanate is used as a curing agent as disclosed in Patent Literature 3 and Patent Literature 4 can be cured at a low temperature and have excellent electrical conductivity, and the flexibility and the adhesiveness of the electroconductive adhesives are not sufficiently studied.

SOLUTION TO THE PROBLEMS

The present inventors conducted thorough studies to develop an electroconductive cured product for connecting an electronic part that is flexible and that has excellent electrical conductivity even in the case of a low curing temperature so that generation of cracks and change in resistance at the time of deformation are suppressed. As a result, the present inventors have found that, when a cured product is characterized by containing a resin having a urethane bond and electroconductive particles and by having storage modulus at 25°C of 50 MPa or higher and 1000 MPa or lower and specific resistance of lower than $2.0\times10^{-4}$ $\Omega\cdot$cm, the cured product has such a flexibility as to be capable of following deformation and has excellent electrical conductivity. Consequently, the present inventors have arrived at the following invention.

That is, the present invention has the following features:

[1] An electroconductive cured product for connecting an electronic part, wherein

the electroconductive cured product is a cured product of an electroconductive composition,
the electroconductive cured product comprises a resin having a urethane bond and electroconductive particles,
the electroconductive cured product has storage modulus of 50 MPa to 1000 MPa at 25 °C, and
the electroconductive cured product has specific resistivity of less than $2.0\times10^{-4}$ $\Omega\cdot$cm.

[2] The electroconductive cured product according to the above [1], wherein the electroconductive cured product has thermal conductivity of 5.0 W/m·K or higher.
[3] The electroconductive cured product according to the above [1] or [2], wherein the electroconductive particles are silver particles.
[4] The electroconductive cured product according to any one of the above [1] to [3], wherein an amount of the electroconductive particles is 20% by volume to 50% by volume in a total volume of the electroconductive cured product.
[5] The electroconductive cured product according to any one of the above [1] to [4], wherein the electroconductive cured product further comprises a resin having a urea bond.
[6] The electroconductive cured product according to the above [5], wherein an IR peak area ratio of the urethane bond to the urea bond is 7/3 to 1/9 in the electroconductive cured product.
[7] An electronical device comprising an electronic part and a substrate having an electrical wire, wherein the electroconductive cured product as defined in any one of the above [1] to [6] is interposed between the electronical part and the electronic wire.
[8] The electronical device according to the above [7], wherein the substrate is a stretchable and/or bendable substrate.

ADVANTAGEOUS EFFECTS OF THE INVENTION

In the present invention, the electroconductive cured product is characterized by containing a resin having a urethane bond and electroconductive particles and is characterized by having storage modulus at 25°C of 50 MPa or higher and 1000 MPa or lower and specific resistance of lower than $2.0\times10^{-4}$ $\Omega\cdot$cm. Since the storage modulus at 25°C is set to fall within the above range, the electroconductive cured product can follow deformation when being used for connecting an electronic part, whereby generation of cracks at the time of deformation of the electroconductive cured product can be suppressed. In addition, since the specific resistance is set to fall within the above range, sufficient electrical conductivity can be maintained also when the electroconductive cured product is repeatedly deformed.

BRIEF DESCRIPTION OF THE DRAWINGS

[FIG. 1] FIG. 1 is a schematic diagram showing a cross section of an electronic device in which an electroconductive cured product of the present invention is used.
[FIGS. 2(a) to 2(c)] FIGS. 2(a) to 2(c) show a procedure of manufacturing a mount body in which the electroconductive cured product of the present invention is used, FIG. 2(a) showing a situation in which wires 20 have been formed on a substrate 10, FIG. 2(b) showing a situation in which an electroconductive composition has been applied to each of opposed end portions, of the respective wires 20, between which a gap is present, FIG. 2(c) showing a situation in which an LED chip has been mounted on the electroconductive composition and the electroconductive composition has been cured.

[FIG. 3] FIG. 3 is a cross-sectional view of a tensile test device for the mount body in which the electroconductive cured product of the present invention is used.

DESCRIPTION OF EMBODIMENTS

[Electroconductive Cured Product]

An electroconductive cured product according to the present embodiment is a cured product of an electroconductive composition. In addition, the electroconductive cured product (hereinafter, also simply referred to as "cured product") is a cured product containing at least a resin having a urethane bond and electroconductive particles, and is preferably a cured product containing a binder resin having a urethane bond and electroconductive particles. In addition, the cured product preferably further contains a resin having a urea bond and more preferably further contains a binder resin having a urea bond. The cured product may contain, as different resins, a resin having a urethane bond and a resin having a urea bond or may contain one resin having both a urethane bond and a urea bond.

The electroconductive composition in the present invention is not particularly limited but preferably contains a polyol, and an isocyanate or a blocked isocyanate. That is, examples of the electroconductive cured product include: a reaction product of the polyol and the isocyanate; and a reaction product of the polyol and the blocked isocyanate. The electroconductive cured product is preferably a reaction product of the polyol and the blocked isocyanate from the viewpoint of handling of the electroconductive composition having yet to be cured. It is also preferable that the electroconductive composition further contains a polyamine. When a polyamine is contained, a urea bond (a resin having a urea bond) can be contained in the electroconductive cured product.

Examples of the polyol include polyether polyols, polyester polyols, polycarbonate polyols, polyurethane polyols, polybutadiene polyols, polyisoprene polyols, polycaprolactone polyols, and castor oil-based polyols. These polyols may be used singly, or two or more types of these polyols may be used in combination.

Example of the polyether polyols include aromatic polyether polyols, aromatic-aliphatic copolymerized polyether polyols, aliphatic polyether polyols, and alicyclic polyether polyols.

Examples of the polyester polyol include aromatic polyester polyols, aromatic-aliphatic copolymerized polyester polyols, aliphatic polyester polyols, and alicyclic polyester polyols. Among these polyester polyols, an aliphatic polyester polyol is preferable from the viewpoint of flexibility. Specific examples of a commercially available product of the aliphatic polyester polyol include: ODX-2420 and ODX-2692 (manufactured by DIC CORPORATION); KURARAY POLYOL P-510, KURARAY POLYOL P-1010, KURARAY POLYOL P-2010, and KURARAY POLYOL P-2050 (manufactured by KURARAY CO., LTD.); and NIPPOLLAN 4009, NIPPOLLAN 164, and NIPPOLLAN 141 (manufactured by TOSOH CORPORATION).

Examples of the polycarbonate polyols include aromatic polycarbonate polyols, aromatic-aliphatic copolymerized polycarbonate polyols, aliphatic polycarbonate polyols, and alicyclic polycarbonate polyols.

Examples of the polyurethane polyols include aromatic polyurethane polyols, aromatic-aliphatic copolymerized polyurethane polyols, aliphatic polyurethane polyols, and alicyclic polyurethane polyols.

Among these polyols, the polyester polyols are preferred in the viewpoint of curability and electrical conductivity. In addition, the electroconductive composition may contain a polyol other than polyester polyol in addition to the polyester polyol. The proportion of the polyester polyol in the polyol is preferably 60% by mass or higher, more preferably 80% by mass or higher, further preferably 90% by mass or higher, particularly preferably 95% by mass or higher, and most preferably 98% by mass or higher, and may be 100% by mass.

The polyol has an active hydrogen equivalent weight of preferably 180 g/eq or higher and more preferably 220 g/eq or higher from the viewpoint of the flexibility of the cured product. Meanwhile, the active hydrogen equivalent weight is preferably 1200 g/eq or lower and more preferably 600 g/eq or lower from the viewpoint of the adhesiveness and the electrical conductivity of the cured product. When the active hydrogen equivalent weight is set to fall within the above range, the balance among the flexibility, the adhesiveness, and the electrical conductivity of the cured product becomes more favorable. The active hydrogen equivalent weight of the polyol is measured according to a method described in EXAMPLES.

The polyol has a hydroxyl value, which is not particularly limited but is preferably 50 to 300 mgKOH/g and further preferably 100 to 250 mgKOH/g from the viewpoint of obtaining more favorable electrical conductivity and adhesiveness.

The polyol has a weight-average molecular weight, which is not particularly limited but is preferably 400 to 2000 g/mol and further preferably 450 to 1500 g/mol from the viewpoint of obtaining more favorable electrical conductivity and adhesiveness.

In addition to the polyol component, a compound having one hydroxy group may be further contained unless performances are impaired. Examples of the compound having one hydroxy group include: aliphatic saturated alcohols such as 1-pentanol, octanol, and cyclohexane ethanol; aliphatic unsaturated alcohols such as 10-undecen-1-ol; aromatic alcohols such as 2-phenylethyl alcohol and benzyl alcohol; and furthermore, derivatives and modified products of these compounds. The amount of the compound having one hydroxy group contained per 100 parts by mass of the polyol is preferably 10 parts by mass or smaller, more preferably 5 parts by mass or smaller, and further preferably 3 parts by mass or smaller, and may be 0 parts by mass.

In the present invention, a resin having a urea bond is further contained in the electroconductive cured product, whereby the cured product has increased storage modulus and further improved adhesiveness. Examples of the cured product having a urea bond used in the present invention include: a reaction product of the polyamine and the isocyanate; and a reaction product of the polyamine and the blocked isocyanate. The cured product including a urea bond is preferably a reaction product of the polyamine and the blocked isocyanate from the viewpoint of handling of the composition having yet to be cured.

Examples of the polyamine include: aliphatic polyamines such as chain aliphatic polyamines, cyclic aliphatic polyamines, and aromatic ring aliphatic polyamines; alicyclic polyamines; aromatic polyamines; and furthermore, derivatives and modified products of these polyamines. These polyamines may be used singly, or two or more types of these polyamines may be used in combination. Examples of the derivatives include alkyl derivatives of the polyamines, and examples of the modified products include: epoxy adducts of the polyamines; Mannich reaction products of the polyamines; Michael reaction products of the polyamines; thiourea reaction products of the polyamines; and polymerized fatty acid and/or carboxylic acid reaction products of the polyamines, which are polyamide amines.

The aliphatic polyamines are compounds in each of which at least one amino group is bound to a chain aliphatic hydrocarbon having one or more carbon atoms (excluding compounds each having structure in which an amino group has been directly bound to an aromatic ring), and an aliphatic ring or an aromatic ring may be bound to the chain aliphatic hydrocarbon. In particular, a compound in which an amino group and an aliphatic ring are bound to the chain aliphatic hydrocarbon is referred to as a cyclic aliphatic polyamine, and a compound in which an amino group and an aromatic ring are bound to the chain aliphatic hydrocarbon is referred to as an aromatic ring aliphatic polyamine. Specific examples of the aliphatic polyamines include diethylenetriamine, triethylenetetramine, tetraethylenepentamine, norbomanediamine, m-xylenediamine, and isophorone diamine.

The alicyclic polyamines are compounds in each of which all amino groups are directly bound to an aliphatic ring. Specific examples of the alicyclic polyamines include cyclohexanediamine.

The aromatic polyamines are compounds in each of which at least one amino group is directly bound to an aromatic ring. Specific examples of the aromatic polyamines include diethyltoluenediamine, dimethylthiotoluenediamine, 4,4'-methylenebis[N-(1-methylpropyl)aniline], and aminobenzylamine.

Among these polyamines, an aliphatic polyamine or a modified product thereof is preferable in the viewpoint of easily improving the flexibility. Specific examples of a commercially available product of the aliphatic polyamine or the modified product thereof include: FUJICURE FXJ-8027-H, FUJICURE FXJ-859-C, FUJICURE FXD-821-F, TOHMIDE 280-C, and TOHMIDE TXE-524 (manufactured by T&K TOKA Corporation); JEFFAMINE D-400 (manufactured by TOMOE Engineering Co., Ltd.); and jER CURE FL11 and jER CURE SA1 (manufactured by Mitsubishi Chemical Corporation).

It is also preferable that the aliphatic polyamine or the modified product thereof is combined with a polyamine other than the aliphatic polyamine or the modified product thereof. The proportion of the aliphatic polyamine or the modified product thereof in the polyamine is preferably 60% by mass or higher, more preferably 80% by mass or higher, further preferably 90% by mass or higher, particularly preferably 95% by mass or higher, and most preferably 98% by mass or higher, and may be 100% by mass.

The polyamine has an active hydrogen equivalent weight of preferably 80 g/eq or higher and more preferably 85 g/eq or higher from the viewpoint of achieving obtainment of all of flexibility, adhesiveness, and electrical conductivity. Meanwhile, the active hydrogen equivalent weight of the polyamine is preferably 200 g/eq or lower and more preferably 190 g/eq or lower from the viewpoint of availability and improvement of the adhesiveness. The active hydrogen equivalent weight of the polyamine is preferably 80 to 200 g/eq and more preferably 85 to 190 g/eq. The active hydrogen equivalent weight of the polyamine is measured according to a method described in EXAMPLES.

The polyamine has an amine value, which is not particularly limited but is preferably 150 to 350 KOHmg/g and further preferably 160 to 330 KOHmg/g. If the amine value is within this range, the increase in the viscosity of the electroconductive composition is controlled and the electroconductive composition becomes easy to handle.

The polyamine has a viscosity, which is not particularly limited but is preferably 2000 mPa·s or lower and further preferably 800 mPa·s or lower from the viewpoint of further facilitating handling.

An IR peak area ratio of the urethane bond to the urea bond (urethane bond/urea bond) in the electroconductive cured product is preferably 7/3 to 1/9 and more preferably 6/4 to 2/8. When the proportion of the urea bond is increased, the adhesiveness and the electrical conductivity of the obtained cured product can be made favorable, and, when the proportion of the urethane bond is increased, the flexibility of the obtained cured product can be made favorable. Thus, if the IR peak area ratio (urethane bond/urea bond) is set to fall within the above range, the balance among the flexibility, the adhesiveness, and the electrical conductivity of the cured product becomes more favorable. In particular, in a case where the polyamine that forms a urea bond through a reaction with the isocyanate has an active hydrogen equivalent weight of 180 g/eq or lower, the proportion of the polyol that forms a urethane bond is preferably set to be high, and a mixing ratio as an active hydrogen equivalent weight ratio (polyol/polyamine) in the electroconductive composition is preferably 4/6 to 7/3 and more preferably 5/5 to 7/3. The IR peak area ratio (urethane bond/urea bond) is calculated according to a method described in EXAMPLES.

The total amount of the polyol and the polyamine for forming urethane bonds and urea bonds in the present invention is not particularly limited but is preferably 1% by mass or higher and 50% by mass or lower, further preferably 2% by mass or higher and 30% by mass or lower, and most preferably 3% by mass or higher and 15% by mass or lower with respect to the amount of the entire electroconductive composition. If the total amount of the polyol and the polyamine is set to fall within this range, the balance between the flexibility and the electrical conductivity becomes more favorable.

The electroconductive composition of the present invention preferably contains an isocyanate compound or a blocked isocyanate compound. As an isocyanate that forms the blocked isocyanate compound, a compound having a plurality of isocyanate groups in the molecule thereof (polyisocyanate) is preferable. Examples of the polyisocyanate include: aliphatic polyisocyanates such as hexamethylene diisocyanate (hereinafter, HDI) and isophorone diisocyanate (IPDI); aromatic polyisocyanates such as diphenylmethane diisocyanate (MDI) and tolylene diisocyanate (TDI); and modified products such as isocyanurates, adducts, and biurets of these polyisocyanates. From the viewpoint of obtaining a more favorable flexibility, an aliphatic polyisocyanate or a modified product of the aliphatic polyisocyanate is preferable.

Each of the isocyanates may be a monomer but is preferably an oligomer of the isocyanate or a modified product such as an isocyanurate, an adduct, or a biuret of the oligomer.

The most preferable isocyanate is an oligomer of any of the aliphatic polyisocyanates such as an oligomer of HDI, or a modified product of the oligomer.

Examples of a blocking agent that forms the above blocked isocyanate compound include phenol-based blocking agents, oxime-based blocking agents, alcohol-based blocking agents, lactam-based blocking agents, active methylene-based blocking agents, and pyrazole-based blocking agents. Among these blocking agents, an active methylene-based blocking agent or a pyrazole-based blocking agent is preferable because of the ability thereof to decrease the temperature for a reaction. These blocking agents may be contained singly, or two or more types of these blocking agents may be contained. From the viewpoint of curability and preservation stability, it is preferable that both an active methylene-based blocking agent and a pyrazole-based blocking agent are contained.

Examples of the above active methylene-based blocking agents include dialkyl malonates such as dimethyl malonate, diethyl malonate, dibutyl malonate, 2-ethylhexyl malonate, methylbutyl malonate, diethylhexyl malonate, and diphenyl malonate.

Examples of the above pyrazole-based blocking agents include pyrazole, 3,5-dimethyl pyrazole, 3-methyl pyrazole, and 4-nitro-3,5-dimethyl pyrazole.

Examples of a commercially available product of the above blocked isocyanate compound can include: Duranate SBN-70D, Duranate SBB-70P, and Duranate TPA-B80E (manufactured by Asahi Kasei Corporation); Desmodur BL 3272 MPA, Desmodur BL 3475 BA/SN, and Desmodur BL 3575 MPA/SN (manufactured by Covestro AG); and Trixene BI 7960, Trixene BI 7982, Trixene BI 7991, and Trixene BI 7992 (manufactured by Baxenden Chemicals Limited).

The blending ratio of the isocyanate group of the blocked isocyanate to all the active hydrogen groups of the polyol and the polyamine (NCO group/active hydrogen group) in the present invention is not particularly limited but is preferably 0.7 or higher and lower than 2.0 and further preferably 0.8 or higher and 1.5 or lower. If the blending ratio is within this range, it is possible to exhibit a more favorable adhesiveness of the cured product while maintaining the flexibility thereof.

In the electroconductive composition of the present invention, a catalyst can be further contained unless the performances are impaired. The catalyst is not particularly limited, and examples of the catalyst include organic tin compounds, organic bismuth metal compounds, and tertiary amine compounds. The amount of the catalyst is preferably 1.0% by mass or lower and more preferably 0.1% by mass or lower with respect to the amount of the entire electroconductive composition.

The electroconductive particles used in the present invention are not particularly limited, and examples of the electroconductive particles include particles of silver, copper, gold, platinum, palladium, aluminum, nickel, indium, bismuth, zinc, lead, tin, and carbon black. These electroconductive particles may be used singly, or two or more types of these electroconductive particles may be used in combination. Among these electroconductive particles, silver particles are preferably used from the viewpoint of electrical conductivity.

The electroconductive particles have an average particle diameter D50, which is not particularly limited but is preferably 0.4 μm or larger and 15 μm or smaller. If the D50 is 0.4 μm or larger, the flexibility of the cured product is improved, the storage modulus of the cured product does not become excessively high, and cracks are less likely to be generated at the time of deformation. Considering this, the D50 is more preferably 0.5 μm or larger and further preferably 0.6 μm or larger. Meanwhile, if the D50 is 15 μm or smaller, the adhesive force and the electrical conductivity of the cured product are improved. Considering this, the D50 is more preferably 12 μm or smaller and further preferably 10

μm or smaller.

The electroconductive composition of the present invention may contain one type of electroconductive particles having a single average particle diameter D50 or may contain two or more types of electroconductive particles having different average particle diameters D50. When one type of electroconductive particles having a single average particle diameter D50 is used, the average particle diameter D50 is preferably less than 4.9 μm and more preferably 4.5 μm or smaller. From the viewpoint of improving the adhesive force while maintaining the flexibility, two or more types of electroconductive particles including small-particle-diameter electroconductive particles and large-particle-diameter electroconductive particles are preferably contained. On one hand, the average particle diameter D50 of the small-particle-diameter electroconductive particles is not particularly limited but is preferably 0.4 μm or larger, more preferably 0.5 μm or larger, and further preferably 0.6 μm or larger. Meanwhile, the average particle diameter D50 of the small-particle-diameter electroconductive particles is preferably 2 μm or smaller, more preferably 1.5 μm or smaller, and further preferably 1.2 μm or smaller. On the other hand, the average particle diameter D50 of the large-particle-diameter electroconductive particles is not particularly limited but is preferably 5 μm or larger, more preferably 6 μm or larger, and further preferably 7 μm or larger. Meanwhile, the average particle diameter D50 of the large-particle-diameter electroconductive particles is preferably 15 μm or smaller, more preferably 12 μm or smaller, and further preferably 10 μm or smaller. The blending ratio of the small-particle-diameter electroconductive particles to the large-particle-diameter electroconductive particles (the mass ratio of the small-particle-diameter electroconductive particles to the large-particle-diameter electroconductive particles) is not particularly limited but is preferably 95/5 to 50/50 and further preferably 90/10 to 70/30. If the blending ratio of the small-particle-diameter electroconductive particles to the large-particle-diameter electroconductive particles is set to fall within this range, it is possible to obtain a further flexible cured product while maintaining the electrical conductivity and the adhesiveness thereof.

The shapes of the electroconductive particles are not particularly limited, and examples of the shapes include the shapes of flakes, indefinite and aggregate shapes, spherical shapes, and block-like shapes. The electroconductive particles may have one of these types of shapes or may have two or more of these types of shapes. Among these shapes, the electroconductive particles preferably have at least the shapes of flakes from the viewpoint of preventing decrease in the viscosity at the time of heating.

The average particle diameter D50 in the present invention indicates a particle diameter at a value of 50% in terms of cumulative volume regarding particle diameters measured through a laser diffraction method.

The total amount of the electroconductive particles contained in the electroconductive cured product of the present invention is not particularly limited but is preferably 20% by volume or higher and 50% by volume or lower and further preferably 25% by volume or higher and 45% by volume or lower with respect to the amount of the entire electroconductive composition or electroconductive cured product. If the amount of the electroconductive particles is set to fall within this range, the balance between the flexibility and the electrical conductivity becomes more favorable.

The electroconductive composition of the present invention has an F value of preferably 68% by mass or higher and 90% by mass or lower, more preferably 74% by mass or higher and 88% by mass or lower, and further preferably 81% by mass or higher and 86% by mass or lower. The F value is a numerical value indicating the percentage by mass of a filler in 100% by mass of all solid components contained in the electroconductive composition and is expressed as F value = (percentage by mass of filler/percentage by mass of solid components)×100. Regarding the percentage by mass of the solid components mentioned herein, the solid components exclude solvents and include all of the electroconductive particles, other fillers, resins including the polyol and the polyamine, and other curing agents and additives. When the F value is lower than 68% by mass, the specific resistance tends to become high. Meanwhile, when the F value is higher than 90% by mass, the flexibility and the adhesiveness tend to become low.

The electroconductive cured product of the present invention is preferably a cured product obtained by thermosetting of the electroconductive composition. The heating temperature at the time of the thermosetting may be 80 to 150°C and may be 100°C to 130°C, for example. The heating time is not particularly limited but is preferably about 30 minutes to 60 minutes. The pressure at the time of the heating is preferably normal pressure.

In the electroconductive composition of the present invention, it is possible to further blend an additive such as a thermoplastic resin, an inorganic filler, an electroconductive aid, a pigment, a dye, a dispersant, a defoamer, a leveling agent, a thixotropy imparting agent, a reactive diluent, a flame retardant, an antioxidant, an ultraviolet absorber, a hydrolysis inhibitor, a tackifier, or a plasticizer. The blending amount of the additive is preferably 10% by mass or lower, more preferably 3% by mass or lower, and further preferably 1% by mass or lower with respect to the amount of the entire electroconductive composition.

The electroconductive composition of the present invention can achieve obtainment of all of flexibility, adhesiveness, and electrical conductivity, and thus, is suitably used as an electroconductive adhesive for connecting an electronic part (preferably, an electroconductive adhesive used for flexible hybrid electronics). That is, the electroconductive composition of the present invention can be used as an adhesive for adhering an electronic part in which the cured product of the electroconductive composition is contained. The electroconductive cured product can be suitably used as an adhesive for connecting an electronic part in which the electroconductive cured product is contained. The electroconductive composition of the present invention is applied or printed on a substrate and is cured, whereby the cured product can be used as an alternative to solder, for mounting an electronic part. A method for applying the electroconductive composition on the substrate is not particularly limited, and examples of the method include a screen printing method, a stamping method, a dispensing method, and a squeegee printing method. In addition, by curing the electroconductive composition, the cured product can be used for: joining or mounting a semiconductor element chip part; connecting a circuit; adhering a crystal oscillator or a piezoelectric element; sealing a package; or the like.

The electroconductive cured product of the present invention has storage modulus at 25°C measured by using a viscoelasticity measurement device. The storage modulus is 50 MPa or higher, preferably 100 MPa or higher, and more preferably 150 MPa or higher. Meanwhile, the storage modulus is 1000 MPa or lower, preferably 900 MPa or lower, and more preferably 800 MPa or lower. If the storage modulus is set to fall within the above range, the electroconductive cured product comes to have such a favorable flexibility as to be capable of following stretching and bending of a substrate, and cracking and peeling at a connection portion between an electronic part and a wire are suppressed. The storage modulus of the electroconductive cured product is measured according to a method described in EXAMPLES.

The resin components of the electroconductive cured product each have a resin structure in which active hydrogen reactive groups are present. A shorter length between the active hydrogen reactive groups leads to a shorter distance between crosslinking points in the cured product and leads to a higher storage modulus of the cured product. Furthermore, in a case where the polyamine is contained, the urea bond causes increase in the cohesive strength and increase in the storage modulus.

As the silver particles, small-particle-diameter silver particles may be contained in a larger amount, or large-particle-diameter silver particles may be contained in a larger amount. Even when the silver particle content is the same between the former and latter cases, the storage modulus is easily increased in the former case, and the flexibility is easily maintained in the latter case. By arbitrarily combining these types of silver particles, the storage modulus of the cured product can be adjusted to fall within the above range.

The electroconductive cured product of the present invention has specific resistance of lower than $2.0 \times 10^{-4}$ $\Omega \cdot cm$. The specific resistance is preferably $1.5 \times 10^{-4}$ $\Omega \cdot cm$ or lower and more preferably $1.0 \times 10^{-4}$ $\Omega \cdot cm$ or lower. When the specific resistance is set to fall within the above range, the electrical conductivity of the electroconductive cured product becomes favorable. The lower limit of the specific resistance is not particularly limited, and, from an industrial perspective, the specific resistance only has to be $1.6 \times 10^{-6}$ $\Omega \cdot cm$ or higher and may be $5.0 \times 10^{-6}$ $\Omega \cdot cm$ or higher. The specific resistance of the electroconductive cured product is measured according to a method described in EXAMPLES. In a case where the only silver particles in the electroconductive cured product are large-particle-diameter silver particles (and in particular, in a case where the silver particle content is low), there is a tendency that, when the cured product is deformed, contact points between the silver particles are not easily formed, and the specific resistance easily deteriorates.

The electroconductive cured product of the present invention has thermal conductivity of preferably 5.0 W/m·K or higher. The thermal conductivity is more preferably 6.5 W/m K or higher and further preferably 8.0 W/m K. The upper limit of the thermal conductivity is not particularly limited, and, from an industrial perspective, the thermal conductivity only has to be 80 W/m·K or lower and may be 50 W/m K or lower. If the thermal conductivity is set to fall within the above range, heat conducting properties of the electroconductive cured product become favorable. The thermal conductivity is measured according to a method described in EXAMPLES.

The above electroconductive cured product has shear adhesion force exerted when an oxygen-free copper sheet is used as an adherend. From the viewpoint of the adhesiveness, the shear adhesion force is preferably 2.0 MPa or higher and further preferably 2.5 MPa or higher.

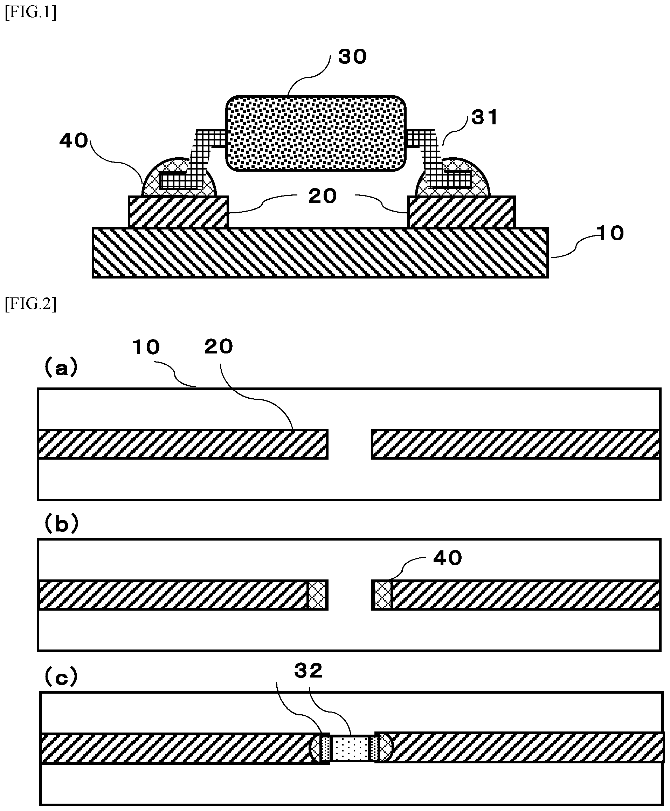

An electronic device according to the present embodiment includes: a substrate having an electrical wire; an electronic part; and the cured product, of the above electroconductive composition, interposed between the electronic part and the electrical wire. Consequently, the wire formed on the substrate and the electronic part can be physically and electrically connected. FIG. 1 is a schematic cross-sectional view showing an example of the electronic device. This electronic device includes: a substrate 10; an electrical wire 20 formed on a surface of the substrate 10; an electronic part 30; and a cured product 40, of the electroconductive composition, interposed between each of the electrical wire 20 and the electronic part 30 (more specifically, a corresponding one of electrodes 31 formed on the electronic part 30). The electronic part 30 and the electrical wire 20 are electrically connected by the cured product 40.

The substrate of the electronic device according to the present embodiment may be a stretchable and/or bendable substrate. The cured product of the above electroconductive composition has flexibility, and thus, can follow stretching and bending of the substrate, whereby cracking and peeling at the connection portion between the electronic part and the electrical wire are suppressed. Therefore, the electronic device according to the present embodiment is flexible and still has high reliability in connection.

The stretchable and/or bendable substrate used in the present invention is not particularly limited, and examples of the substrate include fiber structures, resin films, and rubbers. Examples of the fiber structures include knitted fabric, woven fabric, nonwoven fabric, and paper. Examples of the resin films include polyethylene terephthalate, polyvinyl chloride, polyethylene, polypropylene, polycarbonate, polyethylene naphthalate, polyurethane, polyimide, polymethyl methacrylate, and silicone. Examples of the rubbers include urethane rubber, acrylic rubber, silicone rubber, butadiene rubber, nitrile group-containing rubbers such as nitrile rubber and hydrogenated nitrile rubber, isoprene rubber, vulcanized rubber, styrenebutadiene rubber, butyl rubber, and ethylene-propylene rubber.

EXAMPLES

Hereinafter, the present invention will be specifically described in more detail by means of Examples. Operations, evaluation results, and the like regarding the Examples are based on the measurements performed through the following methods.

<IR Peak Area Ratio (Urethane Bond/Urea Bond)>

From each of electroconductive cured products, a 1-mm-square cured product was cut out, and concentrated nitric acid was dripped on the cured product so as to dissolve electroconductive particles. Then, the cured product having been washed with water and air-dried was thinly spread on a KBr sheet, whereby a sample for evaluation was obtained. The sample was set on an infrared microscope (Nicolet Continu$\mu$m manufactured by Thermo Fisher Scientific Inc.), and an IR spectrum was measured by using an MCT detector as a detector with the resolution being 4 cm$^{-1}$ and with the number of times of integration being 128 through transmission microscopy. An IR peak area ratio (urethane bond/urea bond) was calculated according to the following expression.

IR peak area proportion of urethane bond = $10\times$(peak area in range of 1565 to 1535 cm$^{-1}$)/{peak area in range of 1660 to 1630 cm$^{-1}$) + (peak area in range of 1565 to 1535 cm$^{-1}$)}

IR peak area proportion of urethane bond = $10\times$(peak area in range of 1660 to 1630 cm$^{-1}$)/{peak area in range of 1660 to 1630 cm$^{-1}$) + (peak area in range of 1565 to 1535 cm$^{-1}$)}

The peak area in the range of 1660 to 1630 cm$^{-1}$ was calculated by using, as a baseline, a line connecting the value at 1800 cm$^{-1}$ and the minimum value in the range of 1610 to 1590 cm$^{-1}$, and the peak area in the range of 1565 to 1535 cm$^{-1}$ was calculated by using, as a baseline, a line connecting the minimum value in the range of 1610 to 1590 cm$^{-1}$ and the minimum value in the range of 1500 to 1480 cm$^{-1}$.

<Active Hydrogen Equivalent Weight Ratio>

The hydroxyl value of a polyol was measured as follows. First, 12.5 g of acetic anhydride was dissolved in 50 mL of pyridine so as to accurately fill up the measuring flask, whereby an acetylating reagent was prepared. Then, 2.5 to 5.0 g (this mass is defined as e (g)) of a sample (polyol) was accurately weighed out and supplied into a 100 mL round-bottom flask, and 5 mL of the acetylating reagent and 10 mL of toluene were added to the sample by using a transfer pipette. Then, a cooling tube was attached, and the mixture was stirred and heated at 100°C for one hour. Then, 2.5 mL of distilled water was added to the mixture by using a transfer pipette, and the mixture was further heated and stirred for 10 minutes. After the mixture was cooled for two to three minutes, 12.5 mL of ethanol was added to the mixture, and two to three drops of phenolphthalein were dripped thereinto as an indicator. Then, titration was performed with a 0.5 mol/L ethanolic potassium hydroxide (the titer obtained is defined as a (mL)). Meanwhile, a blank test was performed as follows. That is, 5 mL of the acetylating reagent, 10 mL of toluene, and 2.5 mL of distilled water were supplied into a 100 mL round-bottom flask, the mixture was heated and stirred for 10 minutes, and then, titration was performed in the same manner (the titer obtained is defined as b (mL)). A hydroxyl value was calculated according to the following expression (i) on the basis of these results. In expression (i), f represents a factor of the titrant (0.5 mol/L ethanolic potassium hydroxide). The active hydrogen equivalent weight of the polyol was obtained according to the following expression (ii) on the basis of the obtained hydroxyl value of the polyol.

$$\text{Hydroxyl value of polyol (mg-KOH/g)}$$

$$= \{(b\text{-}a)\times 28.05\times f\}/e \quad \text{(i)}$$

$$\text{Active hydrogen equivalent weight of polyol (g/eq)}$$

$$= 56.11/(\text{hydroxyl value} \times 10^{-3}) \quad \text{(ii)}$$

The active hydrogen equivalent weight of each of polyamines was calculated on the basis of the backbone structure thereof according to the following expression (iii).

$$\text{Active hydrogen equivalent weight of polyamine (g/eq)}$$

$$= \text{molecular weight of polyamine/number of nitrogen atoms with active}$$

$$\text{hydrogens} \quad \text{(iii)}$$

<Elastic Modulus>

Each of electroconductive compositions was applied on a Teflon (registered trademark) film by using a 200-$\mu$m-gap applicator. The electroconductive composition was heated by using a hot-air dryer at 130°C for 60 minutes so as to be cured, and then, was cooled to room temperature. Then, the resultant coating film was cut into a size of 4 mm×300 mm and peeled from the Teflon film, whereby a test piece for elastic modulus evaluation was obtained. The test piece was set on a viscoelasticity measurement device (DVA-200 manufactured by IT Keisoku Seigyo Kabushiki Kaisha (provisional translation: IT Measurement & Control Corporation)), and the device was moved under the conditions of a strain of 0.1%, a frequency of 10 Hz, a temperature increase rate of 4°C/min, and a measurement temperature range of -10°C to 100°C, whereby storage modulus at 25°C was obtained.

<Specific Resistance>

Each of the electroconductive compositions was applied on a PET film by using a 50-$\mu$m-gap applicator. The electroconductive composition was heated by using a hot-air dryer at 130°C for 60 minutes so as to be cured, and then, was cooled to room temperature. Then, the resultant coating film was cut into a size of 10 mm×35 mm, whereby a test piece for specific resistance evaluation was obtained. The film thickness of the test piece was measured by using a thickness gauge (SMD-565L manufactured by TECLOCK Co., Ltd.), and the sheet resistance of the test piece was measured by using Loresta-GP (MCP-T610 manufactured by Mitsubishi Chemical Analytech Co., Ltd.). The measurement was performed on four such test pieces, and, by using the average value of the four measurement values, specific resistance was calculated to obtain electrical conductivity.

<Change in Resistance>

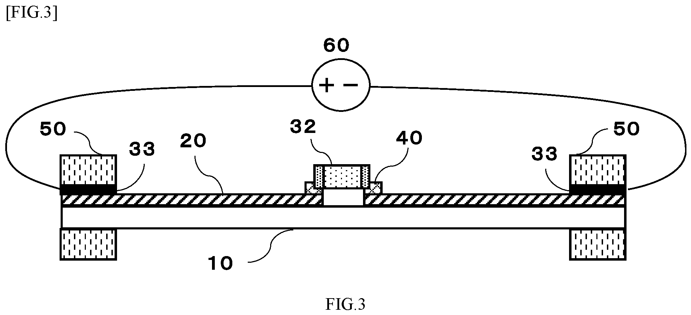

As shown in FIG. 3, each of mount bodies was connected to a power supply 60 and repeatedly stretched and contracted 100 times at an elongation rate of 20%. In a case where an LED chip of the mount body was kept on even after the stretching and contraction, the change in the resistance of the mount body was determined to be 'good'. Meanwhile, in a case where the LED chip was not kept on any more after the stretching and contraction, the change in resistance of the mount body was determined to be 'bad'.

<Checking as to Presence/Absence of Cracks>

As shown in FIG. 3, each of the mount bodies was connected to the power supply and repeatedly stretched and contracted 100 times at an elongation rate of 20%. Then, the region of an electroconductive cured product 40 was observed by using a microscope (OLS4100 available from Olympus Corporation). In a case where no cracks were observed, it was determined that cracks were 'absent'. Meanwhile, in a case where cracks were observed, it was determined that cracks were 'present'.

<Thermal Conductivity>

Each of electroconductive compositions was applied on a Teflon (registered trademark) film by using a 200-$\mu$m-gap applicator. The electroconductive composition was heated by using a hot-air dryer at 130°C for 60 minutes so as to be cured, and then, was cooled to room temperature. Then, the resultant coating film was cut into a size of 10 mm×10 mm and peeled from the Teflon film, whereby a test piece for thermal conductivity evaluation was obtained.

The thermal diffusivity, the specific heat, and the density at 25°C of the test piece were measured, and thermal conductivity was calculated according to the following expression.

$$\text{Thermal conductivity } \lambda \text{ (W/mK)} = \alpha \cdot Cp \cdot d$$

$\alpha$ represents the thermal diffusivity (m$^2$/s), Cp represents the specific heat (J/(kg·K)), and d represents the density (kg/m$^3$).

The thermal diffusivity $\alpha$ was measured through the xenon flash method by using the xenon flash analyzer LFA 467 HyperFlash manufactured by NETZSCH Japan K.K. The density d was measured through the Archimedes method. The specific heat Cp was measured through the DSC method by using DSC7020 manufactured by Hitachi High-Tech Corporation.

Examples 1 to 4 and Comparative Examples 1 to 3

<Manufacturing Example of Electroconductive Cured Product>

Various components were added according to each of the blending ratios in Table 1 and were premixed. Then, the mixture was dispersed by using a three-roll mill, to be made into a paste. Consequently, an electroconductive composition was obtained. Thereafter, the electroconductive composition was cured, whereby an electroconductive cured product was obtained. The evaluation results regarding the obtained electroconductive cured product are indicated in Table 1.

<Manufacturing Example of Mount Body>

As shown in FIGS. 2(a) to 2(c), a flexible substrate in which wires 20 (silver wires each having a width of 2 mm and a length of 10 cm) were formed on a substrate 10 (polyurethane film (DUS-605CD available from Sheedom Co., Ltd. and having a thickness of 50 $\mu$m)) was prepared. The wires 20 were provided such that a gap of 2 mm was present therebetween at a center portion. The electroconductive composition was applied on each of chip mounting portions. The chip mounting portions were opposed ends, of the respective wires 20, between which the gap was present. An LED chip 32 (size: 3216) was mounted on the chip mounting portions. Subsequently, the electroconductive composition was heated at 130°C for 60 minutes so as to be cured, whereby an electroconductive cured product 40 was obtained. Consequently, a mount body for evaluation was obtained.

<Evaluation Method for Mount Body>

As shown in FIG. 3, both ends of the mount body manufactured according to the procedure described in "Manufacturing Example of Mount Body" were sandwiched by measurement jigs 50 having wiring-portion electrodes 33 and were connected to the power supply 60. The measurement jigs 50 were moved outward from said both ends at a speed of 10 mm/sec so as to elongate the substrate 10 by 20%, and then the substrate 10 was restored to the initial length. This elongation-restoration operation was repeated 100 times.

[Table 1]

| | | | Ex. 1 | Ex. 2 | Ex. 3 | Ex. 4 | Com. Ex. 1 | Com. Ex. 2 | Com. Ex. 3 |
|---|---|---|---|---|---|---|---|---|---|
| Composition (% by mass) | | Polyol | 4.4 | 4.5 | 5.7 | 2.3 | 4.5 | 2.6 | 6.6 |
| | | Polyamine 1 | 1.5 | | 0.8 | | | | |
| | | Polyamine 2 | | 2.3 | | 4.1 | | | |
| | | Polyamine 3 | | | | | | 5.3 | |
| | | Isocyanate | 12.7 | 13.6 | 12 | 14.0 | 12.4 | 12.5 | 18.1 |
| | | Electroconductive particles 1 | 73.3 | 39.8 | 61.1 | 39.8 | | 79.6 | |
| | | Electroconductive particles 2 | | 39.8 | 20.4 | 39.8 | | | 75.3 |
| | | Electroconductive particles 3 | 8.1 | | | | | | |
| | | Electroconductive particles 4 | | | | | 83.1 | | |
| F value | | | 84.6 | 83.0 | 84.5 | 83.1 | 86.3 | 82.7 | 79.6 |
| IR peak area ratio (urethane bond/urea bond) | | | 3/7 | 4/6 | 5/5 | 1/9 | 10/0 | 1/9 | 10/0 |
| NCO group/active hydrogen group | | | 0.8 | 1.0 | 0.8 | 1.0 | 1.5 | 0.8 | 1.5 |
| Evaluation | | Specific resistance ($\Omega \cdot cm$) | $6.8 \times 10^{-5}$ | $9.9 \times 10^{-5}$ | $1.1 \times 10^{-4}$ | $9.1 \times 10^{-5}$ | $6.0 \times 10^{-5}$ | $1.7 \times 10^{-4}$ | $1.2 \times 10^{-3}$ |
| | | Storage modulus (MPa) | 380 | 210 | 290 | 280 | 30 | 2800 | 20 |
| | | Thermal conductivity (W/m·K) | 10.6 | 8.3 | 9.1 | 8.7 | 6.5 | 12.1 | 4.3 |
| | | Change in resistance | Good | Good | Good | Good | Bad | Bad | Bad |
| | | Presence/absence of cracks | Absence | Absence | Absence | Absence | Absence | Presence | Absence |

The components in Table 1 are as follows.

Polyol: polyester polyol P-510 (active hydrogen equivalent weight: 250 g/eq, hydroxyl value: 224 KOHmg/g, weight-average molecular weight: 500 g/mol) available from KURARAY CO., LTD.

Polyamine 1: modified aliphatic amine FXD-821-F (active hydrogen equivalent weight: 85 g/eq, amine value: 300 KOHmg/g, viscosity: 65 mPa s) available from T&K TOKA Corporation

Polyamine 2: modified aliphatic amine FXJ-859-C (active hydrogen equivalent weight: 190 g/eq, amine value: 170 KOHmg/g, viscosity: 450 mPa s) available from T&K TOKA Corporation

Polyamine 3: polyoxypropylenediamine D400 (active hydrogen equivalent weight: 224 g/eq, amine value: 415 KOHmg/g, viscosity: 27 mPa·s) available from Huntsman International LLC.

Isocyanate: blocked isocyanate BI 7992 (NCO: an equivalent weight of 456 g/eq) available from Baxenden Chemicals Limited

Electroconductive particles 1: flake silver P791-24 (D50: 0.7 μm) available from Metalor Technologies Japan K.K.

Electroconductive particles 2: block-like silver P318-41 (D50: 9.0 μm) available from Metalor Technologies Japan K.K.

Electroconductive particles 3: block-like silver P853-11 (D50: 8.0 μm) available from Metalor Technologies Japan K.K.

Electroconductive particles 4: block-like silver P853-12 (D50: 4.9 μm) available from Metalor Technologies Japan K.K.

In each of Examples 1 to 4, a resin having a urethane bond and electroconductive particles were contained, the storage modulus at 25°C was 50 MPa or higher and 1000 MPa or lower, and the specific resistance was lower than $2.0 \times 10^{-4}$ Ω·cm. Consequently, even when the mount body was repeatedly stretched and contracted, no cracks were generated, and no significant increase in the resistance value occurred, whereby the LED was able to be kept on.

In Comparative Example 1, the storage modulus was lower than 50 MPa, whereby no cracks were generated. However, in Comparative Example 1, the resistance value was increased at the time of stretching and contraction, whereby the LED was turned off. In Comparative Example 2, the storage modulus was higher than 1000 MPa, whereby cracks were generated, and the mounted LED chip was peeled. In Comparative Example 3, the initial electrical conductivity was higher than $2.0 \times 10^{-4}$ Ω·cm. Thus, in Comparative Example 3, although no cracks were generated, the resistance value was increased, whereby the LED was turned off.

INDUSTRIAL APPLICABILITY

As described above, the electroconductive cured product of the present invention allows a flexible cured product having excellent electrical conductivity and adhesiveness to be formed at a low temperature and particularly is very suitable as a joining material between an electronic part and a wire formed on a flexible substrate.

DESCRIPTION OF THE REFERENCE CHARACTERS

10   substrate
20   electrical wire
30   electronic part
31   electrode
32   LED chip
33   wiring-portion electrode
40   electroconductive cured product
50   measurement jig
60   power supply

**Claims**

1. . An electroconductive cured product for connecting an electronic part, wherein

   the electroconductive cured product is a cured product of an electroconductive composition,
   the electroconductive cured product comprises a resin having a urethane bond and electroconductive particles,
   the electroconductive cured product has storage elastic modulus of 50 MPa to 1000 MPa at 25 °C, and
   the electroconductive cured product has specific resistivity of less than $2.0 \times 10^{-4}$ Ω·cm.

2. . The electroconductive cured product according to claim 1, wherein the electroconductive cured product has thermal conductivity of 5.0 W/m·K or higher.

3. . The electroconductive cured product according to claim 1 or 2, wherein the electroconductive particles are silver particles.

4. . The electroconductive cured product according to claim 1 or 2, wherein an amount of the electroconductive particles is 20% by volume to 50% by volume in a total volume of the electroconductive cured product.

5. . The electroconductive cured product according to claim 1 or 2, wherein the electroconductive cured product further comprises a resin having a urea bond.

6. . The electroconductive cured product according to claim 5, wherein an IR peak area ratio of the urethane bond to the urea bond is 7/3 to 1/9 in the electroconductive cured product.

7. . An electronical device comprising an electronic part and a substrate having an electrical wire, wherein the electroconductive cured product as defined in claim 1 or 2 is interposed between the electronical part and the electronic wire.

8. . The electronical device according to claim 7, wherein the substrate is a stretchable and/or bendable substrate.

[FIG.1]

**30**

**31**

**40**

**20**

**10**

[FIG.2]

**(a)**

**10**   **20**

**(b)**

**40**

**(c)**

**32**

[FIG.3]

FIG.3

## INTERNATIONAL SEARCH REPORT

| International application No. |
|---|
| **PCT/JP2022/032964** |

**A. CLASSIFICATION OF SUBJECT MATTER**

*H05K 3/32*(2006.01)i; *C08G 18/00*(2006.01)i; *H01B 1/22*(2006.01)i
FI:    H05K3/32 B; H01B1/22 Z; C08G18/00 K

According to International Patent Classification (IPC) or to both national classification and IPC

**B. FIELDS SEARCHED**

Minimum documentation searched (classification system followed by classification symbols)

H05K3/32; C08G18/00; H01B1/22

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/090757 A1 (NAMICS CORP) 07 May 2020 (2020-05-07) paragraphs [0002], [0023], [0034], [0046] | 1, 3-4, 7-8 |
| Y | | 2, 5-6 |
| Y | JP 7-286148 A (SUMITOMO METAL MINING CO LTD) 31 October 1995 (1995-10-31) paragraph [0012] | 2 |
| Y | JP 2005-298812 A (TOYO INK MFG CO LTD) 27 October 2005 (2005-10-27) paragraphs [0006]-[0008] | 5-6 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 November 2022** | **22 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**17**

INTERNATIONAL SEARCH REPORT
**Information on patent family members**

International application No.

**PCT/JP2022/032964**

| Patent document cited in search report | | | Publication date (day/month/year) | Patent family member(s) | | | Publication date (day/month/year) |
|---|---|---|---|---|---|---|---|
| WO | 2020/090757 | A1 | 07 May 2020 | US 2021/0380850 A1 paragraphs [0003], [0044], [0054], [0066] | | | |
| | | | | CN 112955481 | A | | |
| | | | | KR 10-2021-0084497 | A | | |
| | | | | TW 202031838 | A | | |
| JP | 7-286148 | A | 31 October 1995 | (Family: none) | | | |
| JP | 2005-298812 | A | 27 October 2005 | (Family: none) | | | |

Form PCT/ISA/210 (patent family annex) (January 2015)

18

**EP 4 422 364 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5200662 B
- JP 2018048286 A
- JP 2020150236 A
- JP 4467439 B